# EUROPÄISCHE PATENTSCHRIFT

(11) **EP 0 415 111 B1**
(45) Veröffentlichungstag und Bekanntmachung des Hinweises auf die Patenterteilung: **28.02.1996**
(21) Anmeldenummer: 90114780.1
(22) Anmeldetag: 01.08.1990
(51) Int. Cl.: H03K 5/19, G06F 1/04

(54) **Betriebs-Ersatz-Taktversorgung für digitale Systeme**
Back-up clock supply for digital systems
Alimentation d'un système en impulsions d'horloge de secours pour systèmes digitaux

(30) Priorität: 28.08.1989 DE 3928401
(43) Veröffentlichungstag der Anmeldung: 06.03.1991
(73) Patentinhaber: SIEMENS AKTIENGESELLSCHAFT, D-80333 München (DE)
(72) Erfinder: Sarközi, Imre, Dipl.-Ing., D-8000 München 70 (DE)

(56) Entgegenhaltungen:
- DE-B- 2 125 940
- US-A- 3 803 568
- US-A- 3 965 432
- US-A- 4 025 874
- US-A- 4 185 245
- US-A- 4 691 126

## Beschreibung

Die Erfindung betrifft eine Betriebs-Ersatz-Taktversorgung nach dem Oberbegriff des Patentanspruchs 1.

Bei digitalen Datenverarbeitungssystemen, Multiplexsystemen, Vermittlungen und insbesondere Cross-Connect-Multiplex-Systemen in synchronen Netzen wird im allgemeinen eine Ersatz-Taktversorgung vorgesehen. In größeren Systemen arbeiten mehrere Geräteeinheiten synchron mit einem Systemtakt, wodurch Datensignale parallel verarbeitet werden können. Um eine höhere Betriebssicherheit zu erreichen, werden zwei oder mehr miteinander gekoppelte zentrale Taktsignale allen Einheiten angeboten. Die zentralen Taktsignale werden von Quarz-Oszillatoren (VCO's) geliefert, die ihrerseits auf ein hochgenaues Normal-Taktsignal synchronisiert sind. Bei Ausfall der Normalfrequenz ist die Frequenzgenauigkeit der Quarzoszillatoren ausreichend groß, um eine weitere Funktion des Systems zunächst zu gewährleisten. Bei einem Ausfall des Betriebstakt-Oszillators, dessen Reparatur oder bei einer Unterbrechung eines Takt-Signalweges war es bisher üblich, auf ein Ersatz-Taktsignal umzuschalten. Hierbei kommt es jedoch in der Regel zu erheblichen Störungen während des Überganges vom Betriebs-Taktsignal zu dem Ersatz-Taktsignal, die zu einem größeren Bitverlust und damit auch zu einem Synchronverlust führen konnten. Da in allen Baugruppen dieselbe Taktausfallschaltung vorzusehen ist, ist eine einfache und kostengünstige Lösung notwendig. Aus der US-Patentschrift 3,803,568 ist eine Taktversorgung nach dem Oberbegriff des Anspruchs 1 bekannt. Die Auslegeschrift DE-B 21 25 940 betrifft eine Schaltungsanordnung zur betriebssicheren Verstärkung einer regelmäßigen Impulsfolge, wie z.B. eines Taktsignals. Eine Schaltunganordnung ist dazu vorgesehen, welche aus um 120° zueinander phasenverschobenen, amplitudengleichen harmonischen Spektralanteilen von zwei Taktsignalen eine Resultante bildet und aus dieser ein resultierendes Taktsignal ableitet.

Aufgabe der Erfindung ist es, eine einfache Betriebs-Ersatz-Taktversorgung vorzusehen, die eine Verwendung des Ersatz-Taktsignals ohne Bitfehler ermöglicht und einfach realisierbar ist.

Die Aufgabe wird durch die im Patentanspruch 1 angegebene Betriebs-Ersatz-Taktversorgung gelöst.

Vorteilhafte Ausbildungen sind in den Unteransprüchen angegeben.

Vorteilhaft ist, daß die Umschaltung durch eine Addition ersetzt wird. Bei Ausfall eines der Taktsignale ergibt sich ein kontinuierlicher Übergang auf das andere Taktsignal. Der maximale theoretische Phasensprung kann nur 180° betragen.

Vorteilhaft ist, daß der Phasensprung durch ein Filter in eine langsame Phasenänderung umgesetzt wird.

Vorteilhaft ist, wenn die Grundschwingungen der zu addierenden Rechtecksignale verwendet werden, da deren Spektralanteile überwiegen.

Für besondere Anwendungsfälle, insbesondere wenn mehrere phasenverschobene Takte im System benötigt werden, kann auch die erste Oberschwingung oder eine weitere Oberschwingung zur Gewinnung eines resultierenden Taktsignals mit der doppelten bzw. mehrfachen Systemfrequenz verwendet werden.

Ausführungsbeispiele der Erfindung werden anhand von Figuren näher erläutert.

Es zeigen
- Figur 1: eine Betriebs-Ersatz-Taktversorgung,
- Figur 2: ein Prinzipschaltbild einer Taktsignal-Summierschaltung,
- Figur 3: ein Vektordiagramm zur Taktsignalsummierung,
- Figur 4: ein Blockschaltbild der Taktsignal-Summierschaltung,
- Figur 5: ein Ausführungsbeispiel der Taktsignal-Summierschaltung und
- Figur 6: ein weiteres Blockschaltbild für eine weitgehend digitalisierte Summierschaltung.

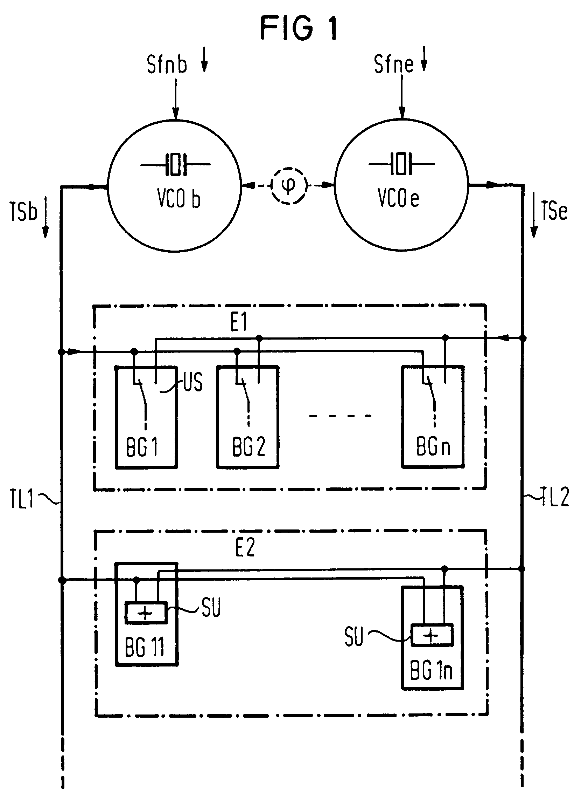

Die in Figur 1 dargestellte Betriebs-Ersatz-Taktversorgung enthält eine erste Geräteeinheit E1 (Einsatz) mit mehreren Baugruppen BG1-BGn. Jeder dieser Baugruppen ist ein Betriebs-Taktsignal TSb von einem Betriebstakt-Oszillator VCOb über eine erste Taktleitung TL1 und ein Ersatz-Taktsignal TSe über eine zweite Taktleitung TL2 von einem Ersatz-Oszillator VGOe zugeführt.

In der zweiten Geräteeinheit E2 wurden auf den Baugruppen BG11 bis BG1n die Umschalter US durch jeweils eine Taktsignal-Summierschaltung SU ersetzt. In den meisten Fällen wird jeder Baugruppe, die mehrere Flachbaugruppen enthalten kann, eine Summationsschaltung zugeordnet sein. Es sind, abhängig von den Sicherheitsanforderungen und technologischen Notwendigkeiten, auch Lösungen denkbar, bei denen mehreren Baugruppen oder einer Geräteeinheit nur eine Summationsschaltung zugeordnet ist.

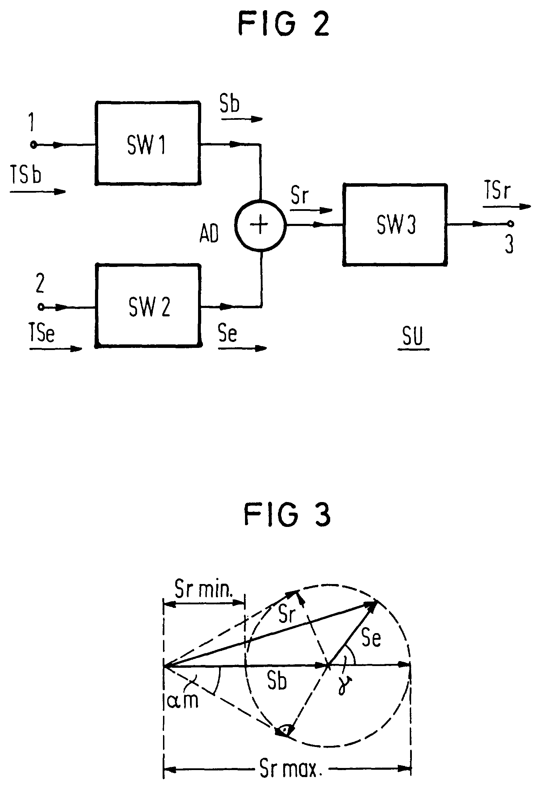

Ein Prinzipschaltbild der erfindungsgemäßen Taktsignal-Summierschaltung SU ist in Figur 2 dargestellt. Sie besteht aus drei Spektralwandlern und einem Addierer. Die Ausgänge des ersten Spektralwandlers SW1 und des zweiten Spektralwandlers SW2 sind über einen Addierer AD zusammengefaßt, dessen Ausgang mit dem Eingang des dritten Spektralwandlers SW3 verbunden ist.

Dem Eingang 1 des ersten Spektralwandlers SW1 wird das Betriebs-Taktsignal TSb zugeführt und dem Eingang 2 des zweiten Spektralwandlers SW2 das Ersatz-Taktsignal TSe. Am Ausgang 3 soll ein resultierendes Taktsignal TSr mit der Frequenz der Grundschwingung oder einer Oberschwingung abgegeben werden. Hierzu werden die Spektralanteile der gewünschten Harmonischen gewichtet addiert und die Harmonische herausgefiltert. Die Filterung kann hierbei vor oder nach der Addition erfolgen. Im ersten Fall filtern die Spektralwandler SW1, SW2 die gewünschte Harmonische heraus; im zweiten Fall liefern sie Impulse, in denen die gewünschte Harmonische mit einem möglichst hohen Anteil enthalten ist. Im zweiten Spektralwandler wird die Amplitude der ausgewählten oder auszuwählenden Harmonischen verkleinert, beispielsweise, wie in Figur 3 dargestellt ist, halbiert. Das so gewonnene Ersatz-Spektralsignal Se wird zu dem Betriebs-Spektralsignal Sb, das vom ersten Spektralwandler abgegeben wird, addiert. Das resultierende Signal Sr - als solches wird stets die resultierende ausgewählte Harmonische verstanden - wird im dritten Spektralwandler SW3 beispielsweise wieder in ein Rechtecksignal umgesetzt, das am Ausgang 3 der Taktsignalsummierschaltung als resultierendes Taktsignal TSr abgegeben wird.

Das in Figur 3 dargestellte Vektordiagramm gilt für ein Amplitudenverhältnis von 2 : 1 des Betriebs-Spektralsignals Sb zu dem Ersatz-Spektralsignal Se. Der Phasenunterschied γ zwischen den Spektralsignalen kann entsprechend dem Phasenunterschied zwischen den Taktsignalen zwischen 0° und 180° liegen. Bei Phasengleichheit addieren sich beide Signale zu einem maximalen resultierenden Signal Srmax; bei Gegenphasigkeit verbleibt lediglich ein minimales resultierendes Signal Srmin. Solange beide Spektralsignale vorhanden sind, können sich lediglich Phasenschwankungen von ± αₘ = ± 30° ergeben.

Je kleiner das Ersatz-Spektralsignal Se ist, desto geringer sind diese Phasenschwankungen. Bei Ausfall des Betriebs-Taktsignals TSb und damit bei Ausfall des Betriebs-Spektralsignals muß das verbleibende Ersatz-Spektralsignal jedoch in der Lage sein, den dritten Spektralwandler auszusteuern. Günstig ist daher ein Verhältnis von Sb : Se > 1,5. Sehr günstig ist ein Verhältnis von 2 : 1, weil sowohl beim Ausfall von TSb als auch bei gegenphasigen Taktsignalen das resultierende Signal Sr gleich ist.

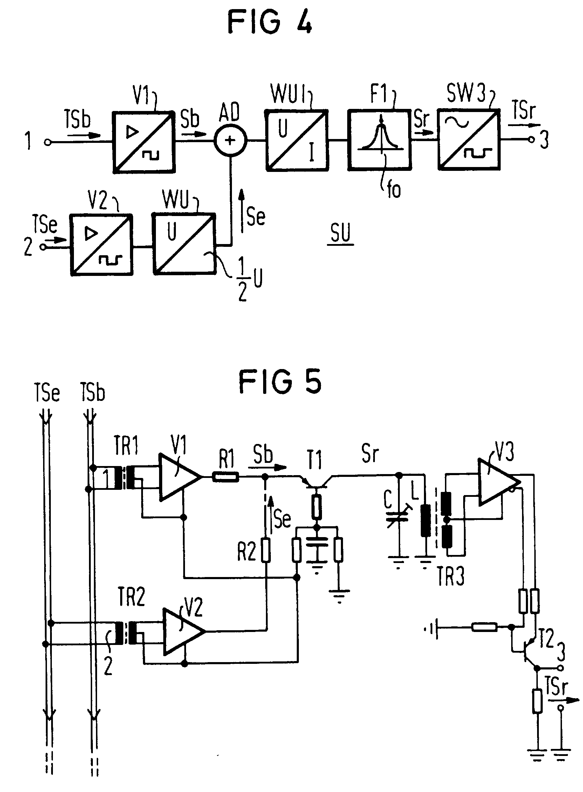

Die Taktsignal-Summierschaltung ist in Figur 4 als Blockschaltbild dargestellt. Die Taktsignale TSb und TSe werden jeweils einen Verstärker V1 bzw. V2 zugeführt, die als Begrenzer arbeiten und gegebenenfalls auch als Pegelumsetzer dienen. Dem zweiten Verstärker V2 ist ein Spannungswandler WU nachgeschaltet. Dessen Ausgang und der Ausgang des ersten Verstärkers sind mit Eingängen des Addierers AD verbunden. An dessen Ausgang ist die Reihenschaltung eines Spannungs-Strom-Wandlers WUI eines Filters FI und des dritten Spektralwandler SW3 angeschaltet.

Die Spektralsignale Sb und Se werden in Form von Rechteckimpulsen addiert und über dem Spannungs-Strom-Wandler WUI dem als Schwingkreis ausgebildeten Filter FI zugeführt, dessen Resonanzfrequenz mit der ausgewählten Harmonischen übereinstimmt, das das resultierende Taktsignal Sr abgibt. Hier wird also das zweite Prinzip durch Addition von Rechtecksignalen und Herausfiltern der gewünschten Harmonischen realisiert. Durch diese Schaltungsanordnung ergibt sich ein geringer Schaltungsaufwand.

Nach dem Vektordiagramm kann es bei Ausgall des Betriebs-Taktsignals TSb in der Regel zu einem Phasensprung von kleiner 180° kommen. Durch den dritten Spektralwandler SW3 wird dieser Phasensprung jedoch in eine kontinuierlich ablaufende Phasenänderung umgesetzt (wobei die Schwingkreiseigenschaften und die Ansteuerung die Geschwindigkeit der Änderung bestimmen). Darüber besteht natürlich auch die Möglichkeit, bei einem größeren Phasenunterschied - ungünstig ist ein Phasenunterschied von 180°, bei dem es zu einem Phasensprung kommt - zwischen Betriebs-Spektralsignal und Betriebs-Ersatzsignal, das Betriebs-Ersatzsignal in der Phase zu verschieben, wobei seine Invertierung immer ausreichend sein müßte.

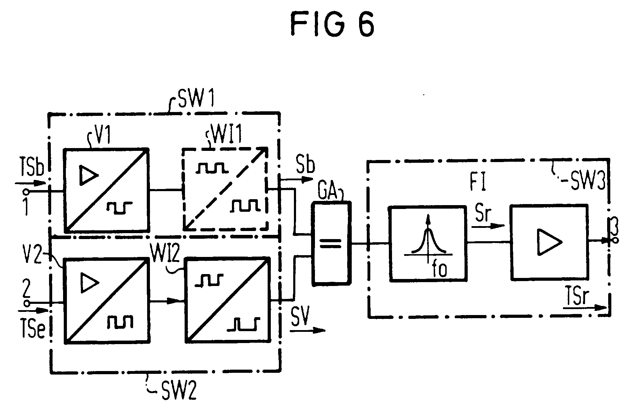

In Figur 5 ist ein Ausführungsbeispiel dargestellt. Zwei Verstärkern (Line-Receivern) werden die Taktsignale TSb und TSe über Transformatoren TR1 bzw. TR2 zugeführt. Die Ausgänge der Verstärker sind jeweils über einen Widerstand R1 bzw. einen doppelt so großen Widerstand R2 zusammengeschaltet und auf den Emitter eines ersten Transistors T1 geführt, der in Basisschaltung arbeitet. Der Collektor des Transistors steuert einen Schwingkreis L, C an, dessen Induktivität von einem dritten Transformator TR3 gebildet wird. An die Sekundärseite dieses Transformators ist ein dritter Verstärker V3 angeschaltet, dessen Ausgänge einen zweiten Transistor T2 zwischen Emitter und Basis ansteuern, der als Pegelumsetzer arbeitet und an seinem Collektor das resultierende Taktsignal TSr im TTL-Pegel abgibt.

In Figur 6 ist eine weitgehend digital arbeitende Version der Taktsignal-Summierschaltung dargestellt. Die Taktsignale TSb und TSe werden zunächst auf einen der verwendeten Schaltkreistechnik endtsprechenden Pegel in den Verstärker V1 bzw. V2 umgesetzt. Der Ausgang des ersten Verstärkers V1 ist direkt mit einem Eingang eines Gatters GA verbunden, während der Ausgang des zweiten Verstärkers V2 über einem Impulswandler WI2 auf einen zweiten Eingang des Gatters geführt ist. Dieses kann ein ODER-Gatter, ein UND-Gatter oder ein EXCLUSIV-ODER-Gatter sein.

Der Gatterausgang ist auf das Filter FI geführt, dessen Ausgang in bekannter Weise mit dem dritten Spektralwandler SW3 verbunden ist. Der Impulswandwandler WI2 verkürzt beispielsweise die logische "1" der Taktsignalimpulse TSe. Folgt die Zusammenfassung durch ein ODER-Gatter, so wird - wenn die logischen "Einsen" beider Taktsignale zusammenfallen - nur daß Betriebs-Taktsignal TSb durchgeschaltet. Fällt dagegen die logische "1" des unsymmetrischen Taktsignals TSV mit der logischen "0" des Betriebs-Taktsignals zusammen, so ergibt sich ein entsprechend der ODER-Funktion geändertes Ausgangssignal des Gatters GA. Natürlich muß sichergestellt werden, daß bei Ausfall eines Taktes der entsprechende Gattereingang auf der logischen "0" gehalten wird, um eine Bockierung des anderen Taktes zu vermeiden. Im Filter FI erfolgt wieder eine Herausfilterung der Grundschwingung und deren Umsetzung in ein resultierendes Taktsignal im dritten Spektralwandler SW3. Ebenso kann auch eine Oberschwingung herausgefiltert werden.

Allgemein gilt hier als Regel der Dimensionierung der Schaltungsanordnung, daß die zu selektierenden Spektralkomponenten möglichst einen maximalen Anteil haben sollen, um den Filteraufwand niedrig zu halten. Sollte der gewünschte Spektralanteil nicht in den Taktsignalen TSb, Tse vorhanden sein, wird er durch Impulswandler WI1, WI2, am einfachsten Impulsdauerwandler, erzeugt.

## Patentansprüche

1. Betriebs-Ersatz-Taktversorgung für digitale Systeme mit einem Betriebstakt-Oszillator (VCOb), der ein Betriebs-Taktsignal (TSb) abgibt, mit einem Ersatz-Oszillator (VCOe), der ein Ersatz-Taktsignal (TSe) abgibt, und mit mindestens einer Baugruppe (BG1, BG2, ...) der das Betriebs-Taktsignal (TSb) und das Ersatz-Taktsignal (TSe) zugeführt werden, und mit einer Taktsignal-Summierschaltung (SU), die ein resultierendes Taktsignal (TSr) abgibt,
**dadurch gekennzeichnet,**
daß jede Taktsignal-Summierschaltung (SU) gleiche harmonische Spektralanteile des Betriebs-Taktsignals (TSb) und des Ersatz-Taktsignals (TSe) oder gleiche hieraus abgeleitete Spektralsignale (Sb, Se) mit deutlich unterschiedlichen Amplituden zu einem resultierenden Signal (Sr) zusammenfaßt und aus diesem das resultierende Taktsignal (TSr) ableitet.

2. Betriebs-Ersatz-Taktversorgung nach Anspruch 1,
**dadurch gekennzeichnet,**
daß ein erster und ein zweiter Spektralwandler (SW1, SW2) vorgesehen sind, die das Betriebs-Taktsignal (TSb) und das Ersatz-Taktsignal (TSe) in Spektralsignale (Sb, Se) umsetzen, die Grundschwingungen oder gleichen Oberschwingungen entsprechen.

3. Betriebs-Ersatz-Taktversorgung nach Anspruch 1,
**dadurch gekennzeichnet,**
daß der erste und der zweite Spektralwandler (SW1, SW2) als Spektralsignale (Sb, Se) Rechteckimpulse mit 1 : 1 Tastverhältnis abgeben.

4. Betriebs-Ersatz-Taktversorgung nach Anspruch 1,
**dadurch gekennzeichnet,**
daß als erster und/oder zweiter Spektralwandler (SW1, SW2) jeweils ein Begrenzerverstärker (V1, V2) mit nachgeschaltetem Impulswandler (WI1, WI2) vorgesehen sind.

5. Betriebs-Ersatz-Taktversorgung nach den Ansprüchen 1 bis 4,
**dadurch gekennzeichnet,**
daß das Amplitudenverhältnis der zu addierenden Harmonischen oder der harmonischen Spektralanteile 2 : 1 ist.

6. Betriebs-Ersatz-Taktversorgung nach Anspruch 1, 3 oder 4,
**dadurch gekennzeichnet,**
daß als Spektralsignale (Sb, Se) amplitudenbegrenzte Rechteckimpulse unterschiedlicher Dauer logisch zusammengefaßt werden.

7. Betriebs-Ersatz-Taktversorgung nach einem der vorhergehenden Ansprüche 3 bis 6,
**dadurch gekennzeichnet,**
daß ein dritter Spektralwandler (SW3) vorgesehen ist, dem das resultierende Spektralsignal (Sr) zugeführt wird, und daß dieser ein Filter (FI) zur Selektion der gewünschten Harmonischen enthält.

8. Betriebs-Ersatz-Taktversorgung nach Anspruch 7,
**dadurch gekennzeichnet,**
daß als Filter (FI) ein Schwingkreis (L, C) vorgesehen ist.

9. Betriebs-Ersatz-Taktversorgung nach einem der Ansprüche 1 bis 5,
**dadurch gekennzeichnet,**
daß in der Taktsignal-Summierschaltung (SU) als Addierer (AD) ein Transistor (T1) in Basisschaltung vorgesehen ist, dessen Emitter über ohmsche Widerstände (R1, R2) die zu addierenden Spektralsignale (Sb, Se) zugeführt werden und
daß an den Kollektor des Transistors (T1) ein Parallelschwingkreis angeschlossen ist.

## Claims

1. Operating/standby clock supply for digital systems having an operating clock oscillator (VCOb) which emits an operating clock signal (TSb), having a standby oscillator (VCOe) which emits a standby clock signal (TSe), and having at least one assembly (BG1, BG2, ...) to which the operating clock signal (TSb) and the standby clock signal (TSe) are fed, and having a clock signal summing circuit (SU) which emits a resultant clock signal (TSr), characterized in that each clock signal summing circuit (SU) combines identical harmonic spectral components of the operating clock signal (TSb) and of the standby clock signal (TSe) or identical spectral signals (Sb, Se) derived herefrom, having considerably different amplitudes, to form a resultant signal (Sr), and derives the resultant clock signal (TSr) from this signal.

2. Operating/standby clock supply according to Claim 1, characterized in that a first and a second spectral converter (SW1, SW2) are provided, and they convert the operating clock signal (TSb) and the standby clock signal (TSe) into spectral signals (Sb, Se) which correspond to fundamentals or identical harmonics.

3. Operating/standby clock supply according to Claim 1, characterized in that the first and the second spectral converter (SW1, SW2) emit as spectral signals (Sb, Se) square-wave pulses having a duty ratio of 1 : 1.

4. Operating/standby clock supply according to Claim 1, characterized in that a limiter amplifier (V1, V2) with a downstream-connected pulse transformer (WI1, WI2) are respectively provided as the first and/or second spectral converter (SW1, SW2).

5. Operating/standby clock supply according to Claims 1 to 4, characterized in that the amplitude ratio of the harmonics to be added or of the harmonic spectral components is 2 : 1.

6. Operating/standby clock supply according to Claim 1, 3 or 4, characterized in that amplitude-limited square-wave pulses of different duration are logically combined as the spectral signals (Sb, Se).

7. Operating/standby clock supply according to one of the preceding Claims 3 to 6, characterized in that a third spectral converter (SW3) is provided, to which the resultant spectral signal (Sr) is fed, and in that this converter contains a filter (FI) for the selection of the desired harmonics.

8. Operating/standby clock supply according to Claim 7, characterized in that a resonant circuit (L, C) is provided as the filter (FI).

9. Operating/standby clock supply according to one of Claims 1 to 5, characterized in that a common-base transistor (T1) is provided as an adder (AD) in the clock signal summing circuit (SU), to the emitter of which transistor the spectral signals (Sb, Se) to be added are fed via non-reactive resistors (R1, R2), and in that a parallel resonant circuit is connected to the collector of the transistor (T1).

## Revendications

1. Alimentation en cadence de fonctionnement et de secours pour des systèmes numériques, comportant un oscillateur (VCOb) de production de la cadence de fonctionnement, qui fournit un signal de cadence de fonctionnement (TSb), un oscillateur de secours (VCOe), qui fournit un signal de cadence de secours (TSe), et comportant au moins un module (BG1,BG2, ...), auquel sont envoyés le signal de cadence de fonctionnement (TSb) et le signal de cadence de secours (TSe), et comportant un circuit additionneur (SU) de signaux de cadence, qui fournit un signal de cadence résultant (TSr), caractérisé par le fait que chaque circuit additionneur (SU) de signaux de cadence réunit des composantes spectrales harmoniques identiques du signal de cadence de fonctionnement (TSb) et du signal de cadence de secours (TSe) ou des signaux spectraux identiques (Sb,Se), qui sont obtenus à partir de ceux-ci et qui ont des amplitudes nettement différentes, pour former un signal résultant (Sr), et obtient, à partir de ce signal résultant, le signal de cadence résultant (TSr).

2. Alimentation en cadence de fonctionnement et de secours suivant la revendication 1, caractérisé par le fait qu'il est prévu des premier et second transducteurs spectraux (SW1,SW2), qui convertissent le signal de cadence de fonctionnement (TSb) et le signal de cadence de secours (TSe) en des signaux spectraux (Sb,Se), qui correspondent à des oscillations fondamentales ou à des harmoniques identiques.

3. Alimentation en cadence de fonctionnement et de secours suivant la revendication 1, caractérisé par le fait que les premier et second transducteurs spectraux (SW1,SW2) fournissent, en tant que signaux spectraux (Sb,Se), des impulsions rectangulaires ayant un taux d'impulsions 1:1.

4. Alimentation en cadence de fonctionnement et de secours suivant la revendication 1, caractérisé par le fait qu'il est prévu, comme premier et/ou second transducteur spectral (SW1,SW2), un amplificateur limiteur (V1,V2) en aval duquel est branché un convertisseur d'impulsions (WI1,WI2).

5. Alimentation en cadence de fonctionnement et de secours suivant les revendications 1 à 4, caractérisé par le fait que le rapport des amplitudes des harmoniques à additionner ou des composantes spectrales harmoniques est égal à 2:1.

6. Alimentation en cadence de fonctionnement et de secours suivant la revendication 1, 3 ou 4, caractérisé par le fait qu'on réunit logiquement des impulsions rectangulaires, dont l'amplitude est limitée et qui ont des durées différentes, en tant que signaux spectraux (Sb,Se).

7. Alimentation en cadence de fonctionnement et de secours suivant l'une des revendications précédentes 3 à 6, caractérisé par le fait qu'il est prévu un troisième transducteur spectral (SW3), auquel est envoyé le signal spectral résultant (Sr), et que ce dernier comprend un filtre (FI) destiné à sélectionner les harmoniques souhaités.

8. Alimentation en cadence de fonctionnement et de secours suivant la revendication 7, caractérisé par le fait qu'il est prévu comme filtre (FI) un circuit oscillant (L,C).

9. Alimentation en cadence de fonctionnement et de secours suivant l'une des revendications 1 à 5, caractérisé par le fait que dans le circuit additionneur (SU) de signaux de cadence il est prévu, comme additionneur (AD), un transistor (T1) monté en base commune, à l'émetteur duquel les signaux spectraux à additionner (Sb,Se) sont envoyés par l'intermédiaire de résistances ohmiques (R1,R2), et un circuit oscillant parallèle est raccordé au collecteur du transistor (T1) .
